# EUROPEAN PATENT APPLICATION

(11) **EP 2 696 665 A1**
(43) Date of publication of application: **12.02.2014**
(21) Application number: 12767433.1
(22) Date of filing: 04.04.2012
(51) Int. Cl.: H05K 7/20, F24F 7/08, F28F 3/08

(54) **HEAT EXCHANGING APPARATUS**

(30) Priority: 08.04.2011 JP 2011086035; 08.04.2011 JP 2011086036; 08.04.2011 JP 2011086037; 08.04.2011 JP 2011086038; 08.04.2011 JP 2011086039
(71) Applicant: Panasonic Corporation, Kadoma-shi, Osaka 571-8501 (JP)
(72) Inventor: FUNADA, Naoyuki, Chuo-ku Osaka 540-6207 (JP); YASUI, Nobuyuki, Chuo-ku Osaka 540-6207 (JP); SAHASI, Takahiro, Chuo-ku Osaka 540-6207 (JP); KURIHARA, Toyoaki, Chuo-ku Osaka 540-6207 (JP)
(74) Representative: Schwabe - Sandmair - Marx
(86) International application number: PCT/JP2012/002335
(87) International publication number: WO 2012/137490

(57) **Abstract**

A heat exchanging apparatus is disposed inside a cabinet and is provided with a main body case, a blower fan, and a heat exchanger. The heat exchanger is formed by alternately stacking first plates and second plates so as to be spaced apart a predetermined distance from each other. The first plates have an L-shaped blowing lane, and the second plates have a U-shaped blowing lane. A first flow inlet is disposed on a first face of the stacked body, a first flow outlet is disposed on a second face of the stacked body, and a second flow inlet and second flow outlet are disposed on a third face of the stacked body. The first face of the stacked body is oriented toward the blower fan, and the first flow outlet, the second flow outlet, and the second flow inlet are disposed so as to be contiguous to a first vent, a second vent, and a second intake hole, respectively.

## Description

### TECHNICAL FIELD

The prevent invention relates to a heat exchanging apparatus.

### BACKGROUND ART

A base station for cellular phones is also called as a heating element because more than tens of amperes current flow along it. That means cooling of the base station is extremely important for stabilizing operation of it. The base station for the cellular phones thus has the following structure for cooling itself (for example, PTL 1).

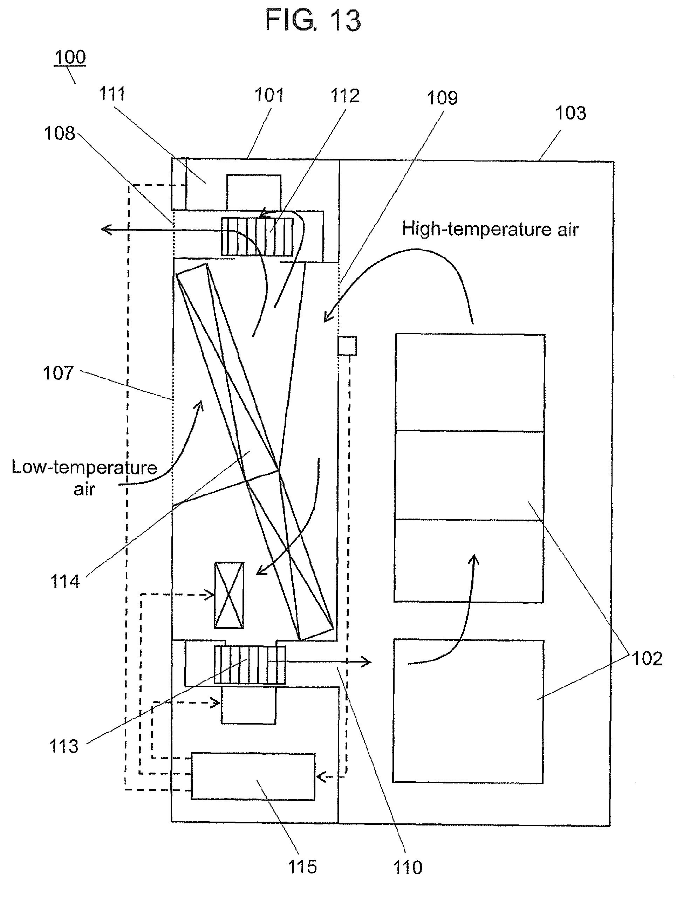

Fig 13 shows a block diagram of an electronic device having a conventional heat exchanger. As shown in Fig. 13, the electronic device 100 comprises cabinet 103 for housing transceiver 102 which is the heating element, and heat exchanging apparatus 101 disposed in an opening of cabinet 103. Heat exchanging apparatus 101 comprises main body case 111, first blower 112 for outdoor air, second blower 113 for indoor air in cabinet 103 and heat exchanger 114. Main body case 111 comprises first intake hole 107 and first vent 118 for the outdoor air, and second intake hole 109 and second vent 110 for the indoor air in cabinet 103.

First blower 112 and second blower 113 are disposed inside main body case 111. Heat exchanger 114 exchanges heat between the outdoor air and the indoor air in cabinet 103 in main body case 111. In addition, the blowers (first blower 112 and second blower 113) and control circuit 115 are disposed in different sections. Control circuit 115 is disposed close to second blower 113 on a side of cabinet 103, not on a side of first blower 112 for blowing the outdoor air containing dust.

Thus, since first blower 112 for the outdoor air, second blower 113 for the indoor air in cabinet 103 and heat exchanger 114 are housed in main body case 111 in conventional heat exchanger 101, main body case 111 is obliged to be large in size. On the other hand, heat exchanging apparatus 101 needs to be downsized because the base station for the cellular phones has been increasingly downsized.

### Citation Lists

### Patent Literatures

PTL1: Unexamined Japanese Patent Application Publication No. 10-190270.

### SUMMARY OF THE INVENTION

The present invention relates to a heat exchanging apparatus disposed in a cabinet, and the heat exchanging apparatus comprises the following structural elements:
a main body case including:
   a first intake hole for sucking outdoor air and a first vent for blowing the outdoor air, both the intake hole and the vent being on a front face of the cabinet; and
   a second intake hole for sucking indoor air within the cabinet and a second vent for blowing the indoor air, both the intake hole and the vent being disposed on a rear face of the cabinet;
an air blower disposed in the main body case for both sucking and blowing the outdoor air; and
a heat exchanger disposed in the main body case for exchanging heat between the outdoor air and the indoor air.

The heat exchanger is formed by alternately stacking first plates and second plates so as to be spaced apart a predetermined distance from each other. The first plates have L-shaped blowing lanes on each surface and the second plates have U-shaped blowing lanes on each surface. A first flow inlet for sucking the outdoor air sucked from the first intake hole into the heat exchanger is disposed on a first face of the stacked body. The first face is any one of faces of the stacked body formed by alternately stacking the first plates and the second plates. A first flow outlet for blowing the outdoor air from the heat exchanger is disposed on a second face of the stacked body, and the second face is adjacent to the first face. A second flow inlet for sucking the indoor air into the heat exchanger and a second flow outlet for blowing the indoor air from the heat exchanger are disposed on a third face of the stacked body, and the third face confronts the second face of the stacked body. The first face of the stacked body is oriented toward the blower fan, and the first flow outlet, the second flow outlet, and the second flow inlet are disposed so as to contiguous to the first vent, the second vent, and the second intake hole, respectively.

The heat exchanging apparatus thus has therein the second intake hole and the second vent on the same face by the U-shaped blowing lane. As a result, the heat exchanger is disposed effectively in the main body case, so that the heat exchanging apparatus can be downsized.

### BRIEF DESCRIPTION OF DRAWINGS

Fig. 1 is a perspective view of an installation example of a heat exchanging apparatus in accordance with an embodiment of the present invention.
Fig. 2 illustrates of an inside of the heat exchanging apparatus in accordance with an embodiment of the present invention.
Fig. 3 illustrates the inside of the heat exchanging apparatus and heating elements therein in accordance with an embodiment of the present invention.
Fig. 4 is an appearance perspective view of the heat exchanging apparatus in accordance with an embodiment of the present invention.
Fig. 5 illustrates stacked plates of a heat exchanger of the heat exchanging apparatus in accordance with an embodiment of the present invention.
Fig. 6 is plan views of a first plate and a second plate of the heat exchanger of the heat exchanging apparatus in accordance with an embodiment of the present invention.
Fig. 7 is a detailed view of the stacked plates of the heat exchanger of the heat exchanging apparatus in accordance with an embodiment of the present invention.
Fig. 8 is an assembly drawing of a main body case of the heat exchanging apparatus in accordance with an embodiment of the present invention.
Fig. 9 is a perspective view of the main body case of the heat exchanging apparatus in accordance with an embodiment of the present invention.
Fig. 10 is a perspective view of a first vent of the heat exchanging apparatus in accordance with an embodiment of the present invention.
Fig. 11 is a sectional view of the first vent of the heat exchanging apparatus in accordance with an embodiment of the present invention.
Fig. 12 is a perspective view of a circulating fan of the heat exchanging apparatus in accordance with an embodiment of the present invention.
Fig. 13 is a block diagram of an electronic device having a conventional heat exchanging apparatus.

### DESCRIPTION OF EMBODIMENTS

An embodiment of the present invention is demonstrated hereinafter with reference to the accompanying drawings.

### EMBODIMENT

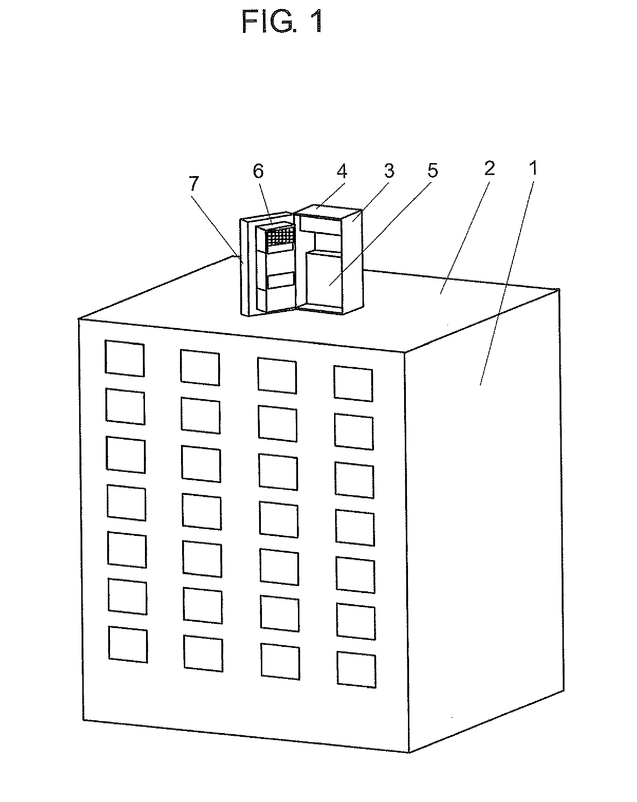

Fig.1 shows a perspective view of an installation example of a heat exchanging apparatus in accordance with the embodiment of the present invention. As shown in Fig. 1, base station 3 for cellular phones is disposed on rooftop 2 of building 1. Base station 3 is equipped with box cabinet 4 and transceiver 5 housed in cabinet 4. Door 7 is disposed in a front opening section of cabinet 4. Heat exchanging apparatus 6 is mounted on door 7 such that it can be accommodated in cabinet 4.

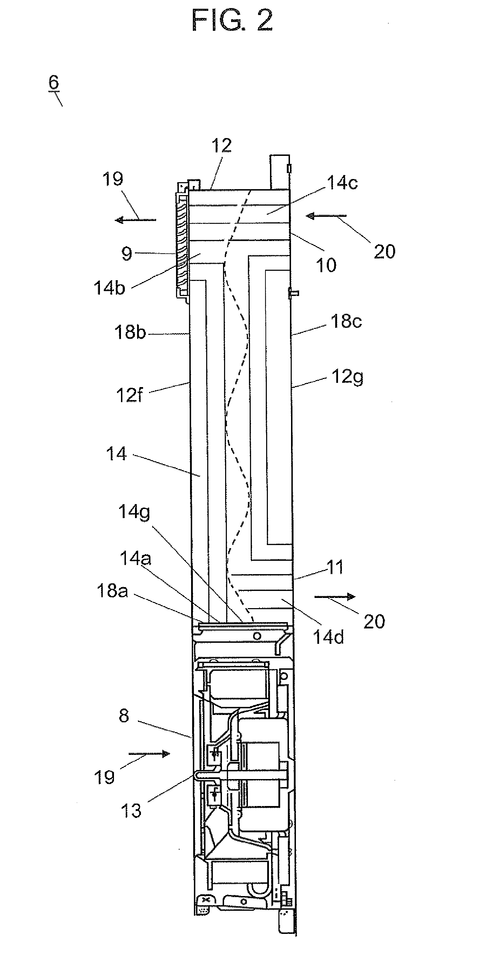

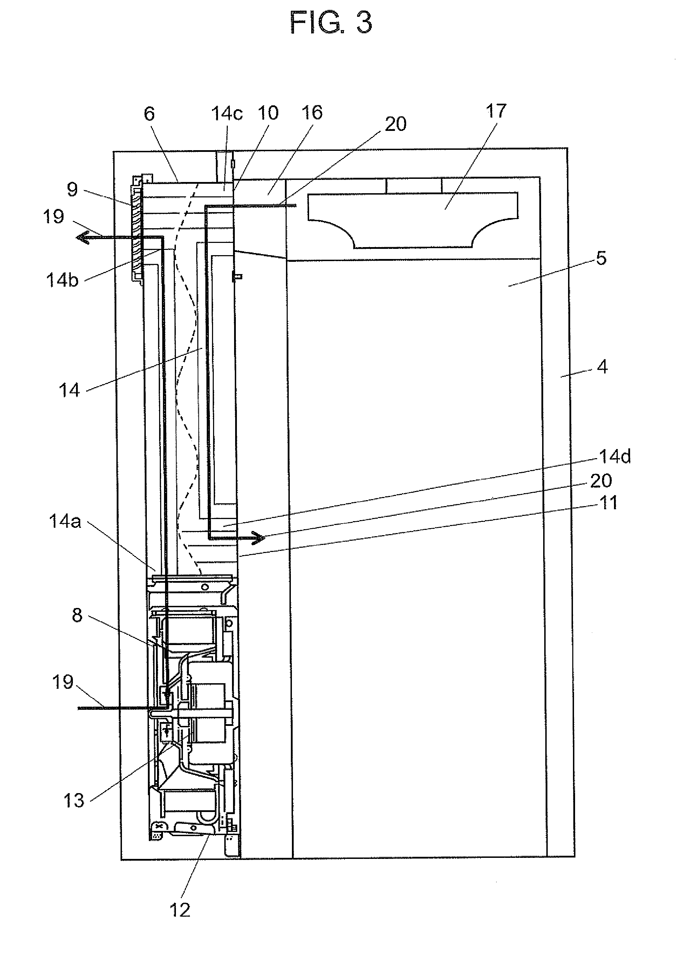

Fig. 2 illustrates an inside of the heat exchanging apparatus in accordance with the embodiment of the present invention. Fig. 3 illustrates the inside of the heat exchanging apparatus and heating elements therein in accordance with the embodiment of the present invention. As shown in Fig. 2 and Fig. 3, heat exchanging apparatus 6 comprises main body case 12, air blower 13 disposed in main body case 12 for sucking and blowing outdoor air 19 and heat exchanger 14 for exchanging heat between outdoor air 19 and indoor air 20 in main body case 12. First intake hole 8 for sucking outdoor air 19 and a first vent 9 for blowing outdoor air 19 are disposed in front face 12f of main body case 12. Second intake hole 10 for sucking indoor air 20 in cabinet 4 and second vent 11 for blowing indoor air 20 are disposed in back face 12g of main body case 12.

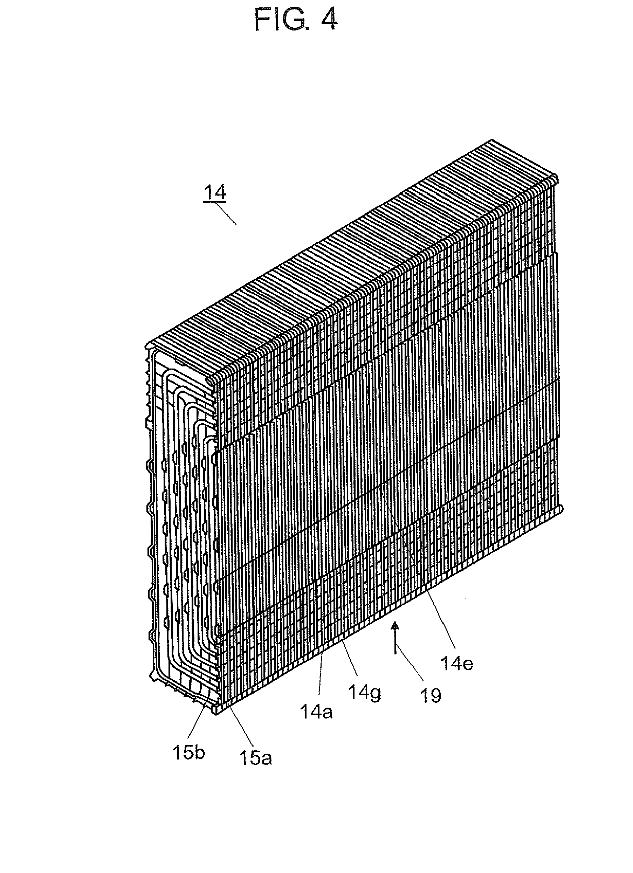

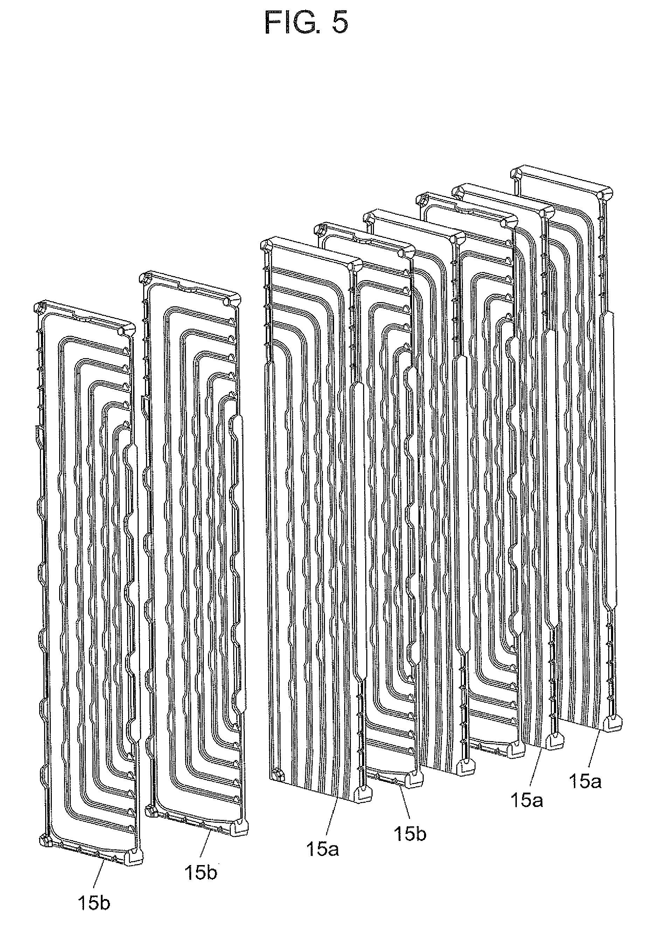

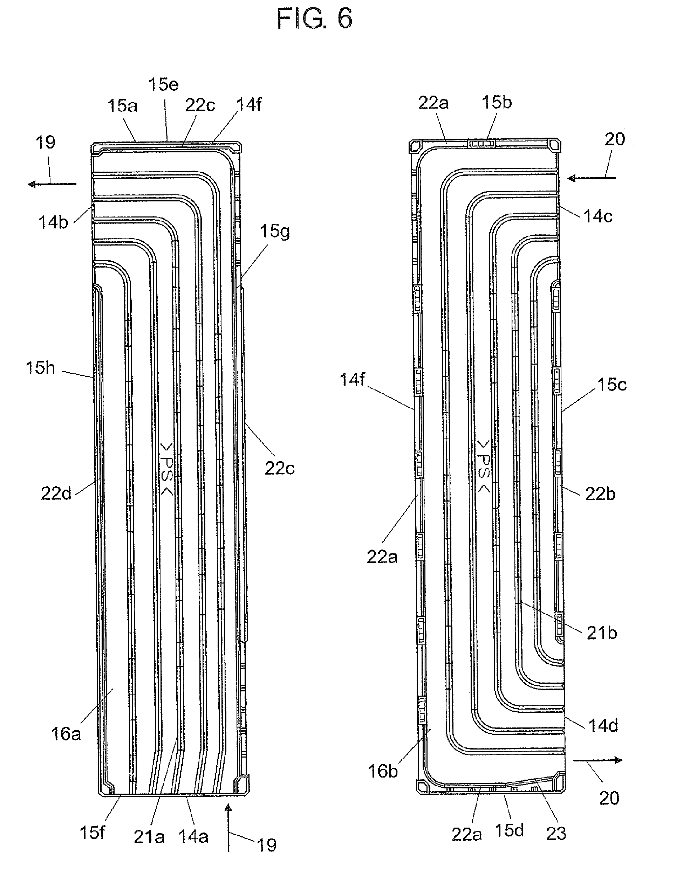

Fig. 4 is an appearance perspective view of the heat exchanger of the heat exchanging apparatus in accordance with the embodiment of the present invention. Fig. 5 illustrates stacked plates of the heat exchanger of the heat exchanging apparatus in accordance with the embodiment of the present invention. Fig. 6 is plan views of a first plate and a second plate of the heat exchanger of the heat exchanging apparatus in accordance with the embodiment of the present invention.

As shown in Fig. 4 to Fig. 6, heat exchanger 14 is approximately rectangular-shaped and is made of synthetic resin. This rectangular shape has short sides and long sides. Heat exchanger 14 is formed by alternately stacking first plates 5a and second plates 15b so as to be spaced apart a predetermined distance from each other. Multiple straightening vanes A 21a and straightening vanes B 21b are disposed on each surface of rectangular-shaped first plates 15a and rectangular-shaped second plates 15b respectively. L-shaped blowing lane 16a and U-shaped blowing lane 16b are disposed on the each surface of first plates 15a and second plates 15b respectively. When first plates 15a and second plates 15b are alternately stacked, this structure allows forming L-shaped blowing lane 16a and U-shaped blowing lane 16b between first plates 15a and second plates 15b with the aid of straightening vane A 21a and straightening vane B 21b. First plates 15a and second plates 15b are made of a thin plate of synthetic resin by a vacuum forming method. Shelter walls described later are disposed around straightening vane A 21a, straightening vane B 21b, first plates 15a and second plates 15b and are formed in a hollow protrusion shape.

Heat exchanger 14 described above will be detailed hereinafter. Outdoor air 19 flows in through first flow inlet 14a disposed at the short side of a lower section of heat exchanger 14 and then moves toward the other short side of an upper section of heat exchanger 14 along L-shaped straightening vane A 21a in L-shaped blowing lane 16a. And outdoor air 19 bends to the long side before the short side of the upper section of heat exchanger 14 and flows out through first flow outlet 14b disposed at the long side of the upper section of heat exchanger 14.

Multiple U-shaped straightening vanes B 21b are disposed on each surface of second plates 15b with their bottoms oriented to the long side. This structure allows indoor air 20 to flow in through second flow inlet 14c disposed at the long side of the upper section of heat exchanger 14 along straightening vane B 21b and then to move along the short side of the upper section of heat exchanger 14 and then to bend at the other long side in U-shaped blowing lane 16b. Indoor air 20 moves along the other long side and bends at the short side of the lower section of heat exchanger 14 and then flows out through second flow outlet 14d disposed at the same long side of the lower section of heat exchanger 14 as second flow inlet 14c is disposed.

As shown in Fig. 2 and Fig. 4, bottom face 14g of heat exchanger 14 serves as first flow inlet 14a for outdoor air 19 in heat exchanger 14 described above. First flow outlet 14b for outdoor air 19 is disposed at one surface of the upper section of heat exchanger 14 and connected to first vent 9. Second flow inlet 14c for indoor air 20 is formed in a position opposite to first flow outlet 14b. Second flow outlet 14d for indoor air 20 is disposed at the same long side of the lower section of heat exchanger 14 as second flow inlet 14c is disposed and connected to second vent 11.

As shown in Fig. 2, air blower 13 is disposed in a position so as to blow outdoor air 19 toward first flow inlet 14a. On the other hand, warmed indoor air 20 in cabinet 4 is sent to second flow inlet 14c for indoor air 20 from circulating fan 17 (not shown in Fig. 2) for the indoor air disposed at an upper section of cabinet 4.

Thus, first flow inlet 14a for sucking outdoor air 19 sucked from first intake hole 8 into heat exchanger 14 is disposed on first stack face 18a, and first stack face 18a is any one of faces of stacked body 18 formed by alternately stacking the first plates and the second plates. First flow outlet 14b for blowing outdoor air 19 from heat exchanger 14 is disposed on second stack face 18b, and second stack face 18b is adjacent to first stack face 18a. Second flow inlet 14c for sucking indoor air 20 into heat exchanger 14 and second flow outlet 14d for blowing indoor air 20 from heat exchanger 14 are disposed in third stack face 18c, and third stack face 18c confronts second stack face 18b.

Air blower 13 is oriented toward first stack face 18a. First flow outlet 14b, second flow outlet 14d and second flow inlet 14c are disposed so as to be contiguous to first vent 9, second vent 11 and second intake hole 10, respectively.

Next, action of heat exchanging apparatus 6 is demonstrated hereinafter with reference to Fig. 3. High-temperature indoor air 20 due to heat generated from transceiver 5 in cabinet 4 is sent into heat exchanger 14 from second intake hole 10 by circulating fan 17 disposed at the upper section of cabinet 4. High-temperature indoor air 20 in cabinet 4 flows in heat exchanger 14 immediately after flowing in second intake hole 10. On the other hand, low-temperature outdoor air 19 is sucked from first intake hole 8 by operation of air blower 13 and sent to first flow inlet 14a. Heat exchanger 14 exchanges heat between low-temperature outdoor air 19 and high-temperature indoor air 20, and resultant cooled indoor air 20 is blown out into cabinet 4 from second vent 11, and outdoor air 19 is again discharged out of heat exchanger 6 from first vent 9.

As shown in Fig. 6, since rectangular-shaped first plates 15a and rectangular-shaped second plates 15b are used for heat exchanger 6, a heat exchange area is large and heat exchange efficiency is good. Indoor air 20 is sucked from a side surface of cabinet 4 shown in Fig. 3 through U-shaped blowing lane 16b and blown out from the side surface of cabinet 4. In addition, since a rotating shaft of circulating fan 17 is disposed orthogonal to a top plate of cabinet 4, space-saving heat exchanging apparatus 6 of which vertical size is downsized is achievable.

As shown in Fig. 6, first shelter wall 22a is disposed at three sides being a periphery of U-shaped blowing lane 16b in second plates 15b. Second shelter wall 22b is disposed at a center of the remaining long side at which the second flow inlet and the second flow outlet of second plates 15b are disposed. To be more specific, second flow inlet 14c and second flow outlet 14d are formed between first shelter wall 22a and second shelter wall 22b. Liquid reservoir 23 is formed by providing a rising slope toward second flow outlet 14d in a lower section of first shelter wall 22a, to be more specific, a section located before second flow outlet 14d of outermost U-shaped blowing lane 16b.

In other words, second flow inlet 14c is vertically disposed above second flow outlet 14d and second flow outlet 14d is vertically disposed below second flow inlet 14c in U-shaped blowing lane 16b. In a front view of U-shaped blowing lane 16b, second plate 15b is formed by four sides including second side 15d crossing at a lowest section of first side 15c having second flow inlet 14c and second flow outlet 14d. Second plate 15b comprises first shelter wall 22a disposed at the periphery including three sides other than first side 15c and second shelter wall 22b disposed at first side 15c other than second flow inlet 14c and second flow outlet 14d. The rising slope toward second flow outlet 14d is provided at second side 15d.

Action of the structure described above is demonstrated hereinafter. High-temperature indoor air 20 warmed in cabinet 4 is cooled by heat exchange with outdoor air 19 in heat exchanger 14. At this time, moisture contained in indoor air 20 may be condensed. Or moisture may be sent into heat exchanger 14 by circulating fan 17. Since liquid reservoir 23 traps the moisture in heat exchanger 14 for preventing it from flowing out of heat exchanger 14. As a result, malfunctions and faults due to immersion of water into electronic devices can be prevented.

As shown in Fig. 4 and Fig. 6, when first plates 15a and second plates 15b are alternately stacked, thermal welding is applied to a periphery of heat exchanger 14 so as to prevent air from escaping from heat exchanger 14 through L-shaped blowing lane 16a and U-shaped blowing lane 16b. To be more specific, the thermal welding is applied to a section where first shelter wall 22a, second shelter wall 22b, third shelter wall 22c and fourth shelter wall 22d are overlapped. At this time, if the thermal welding is applied to an entire face to be welded at a time, dimensional accuracy of heat exchanger 14 is lowered or the thermal welding remains insufficient.

Heat exchanger 14 is temporarily bound by straight welding line 14e along the stacking direction of first plates 15a and second plates 15b, and then the entire target face is thermal-welded, thereby completing heat exchanger 14. This method allows obtaining dimensional accuracy of heat exchanger 14. On top of that, joint face 14f shown in Fig. 6 is provided with waterproof coating after the thermal welding, so that water component cannot enter heat exchanger 14.

As explained above, heat exchanger 14 is formed by alternately stacking first plates 15a and second plates 15b. However, as shown in Fig. 5, multiple first plates 15a or multiple second plates 15b can be successively stacked respectively at ends of the stacked body. For example, two sheets of first plates 15a or second plates 15b can be successively stacked at the ends of the stacked body. Since first plates 15a and second plates 15b are thin sheets made of synthetic resin, the sheets located at the ends are easy to be deformed when they are stacked. The strength of the ends can be thus reinforced by stacking the multiple same to avoid deformation.

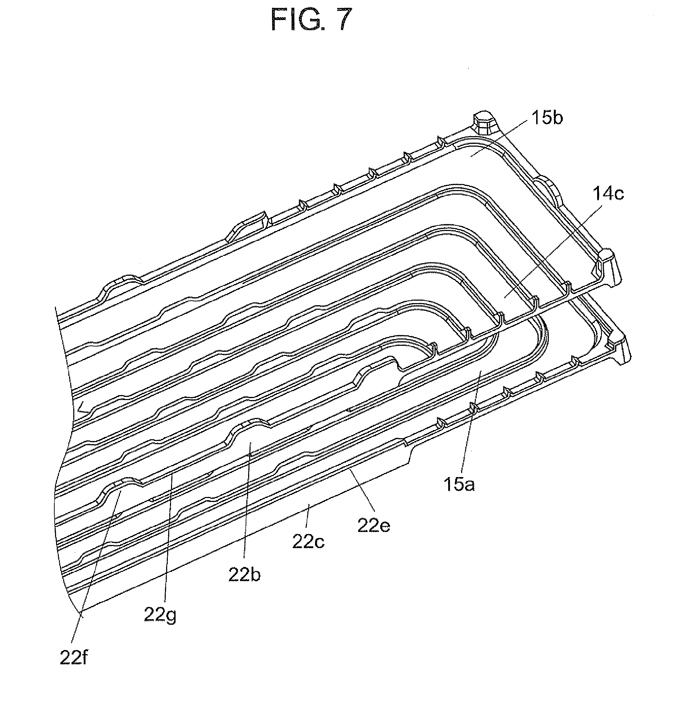

Fig. 7 is a detailed view of the stacked plates of the heat exchanger of the heat exchanging apparatus in accordance with the embodiment of the present invention. As shown in Fig. 7, second shelter wall 22b of second plate 15b fits to third shelter wall 22c of first plate 15a. At this time, first protrusion section 22e which is inserted throughout second shelter wall 22b is formed in third shelter wall 22c. Multiple second protrusion sections 22f to which first protrusion 22e is inserted are formed in second shelter wall 22b. Second protrusion sections 22f are formed at least at both ends of second shelter wall 22b. To be more specific, second shelter wall 22b has therein second protrusion sections 22f and lower sections 22g that are other than second protrusion sections 22f. When second shelter wall 22b and third shelter wall 22c fit together, a top of second protrusion section 22f contacts a top of first protrusion section 22e, and the top of first protrusion section 22e contacts lower section 22g of second shelter wall 22b. First protrusion section 22e and second protrusion section 22f contact at an end of second shelter wall 22b having second flow inlet 14c and second flow outlet 14d. Thus, first plates 15a and second plates 15b are solidly stacked together, and second flow inlet 14c and second flow outlet 14d are formed with great accuracy. The structure described above is common to other flow inlets and flow outlets, and their ends are robustly formed.

As shown in Fig. 6, in a front view of L-shaped blowing lane 16a, first plate 15a is formed by four sides composed of third side 15e and fourth side 15f (short side), and fifth side 15g and sixth side 15h (long side). First plate 15a comprises third shelter walls 22c disposed at a periphery of third side 15e and fifth side 15g of L-shaped blowing lane 16a, and fourth shelter wall 22d disposed at a part of sixth side 15h.

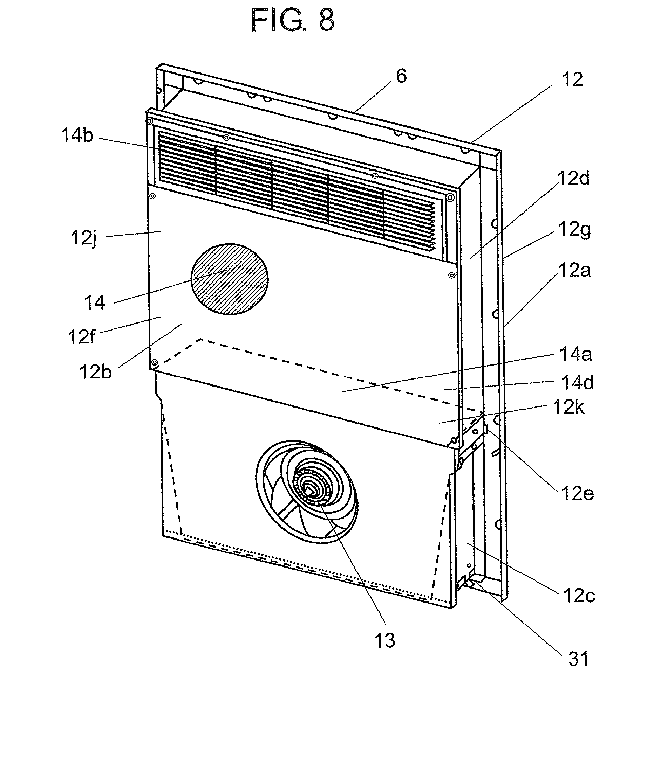

Next, main body case 12 is demonstrated hereinafter with reference to Fig. 8 to Fig. 11. Fig. 8 is an assembly drawing of the main body case of the heat exchanging apparatus in accordance with the embodiment of the present invention. As shown in Fig. 8, main body case 12 comprises back plate 12a in back face 12g, enclosure 12b disposed in front face 12f and fan casing 12c covering air blower 13. To be more specific, frame 12d to which heat exchanger 14 is attached is fixed in back plate 12a. Enclosure 12b covers front face 12j of frame 12d and bottom face 12k of frame 12d. Frame 12d covers heat exchanger 14 at a top plate and side surfaces where no openings such as first flow inlet 14a and first flow outlet 14b are provided. Heat exchanger 14 is provided with drain holes 12e at its lower section of both side surfaces.

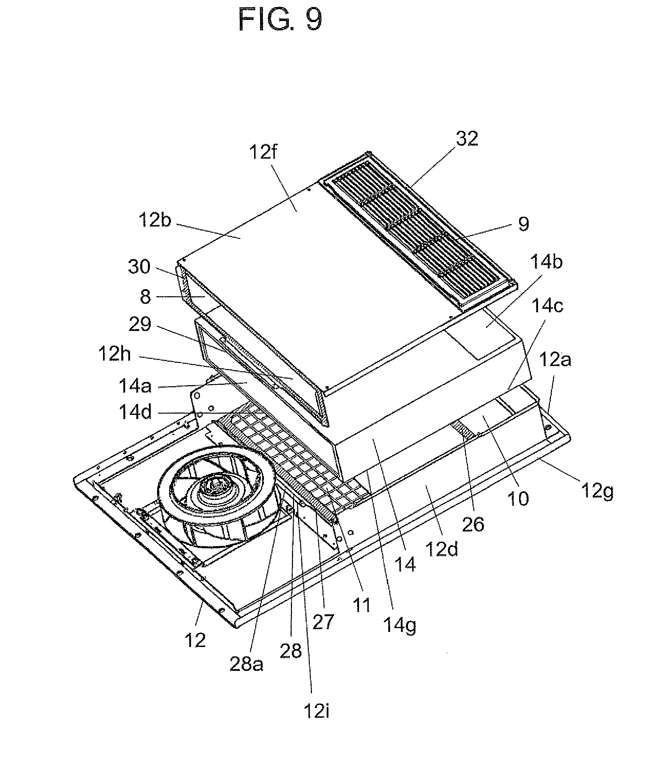

Fig. 9 is a perspective view of the main body case of the heat exchanging apparatus in accordance with the embodiment of the present invention. As shown in Fig. 9, second intake hole 10 and second vent 11 are disposed respectively opposite to second flow inlet 14c and second flow outlet 14d in back plate 12a. Since packing 26 and packing 27 are disposed respectively between second flow inlet 14c and second intake hole 10, and between second flow outlet 14d and second vent 11, air tightness is secured.

In addition, V rib 28 with a descending slope toward front face 12f is disposed in a section where bottom face 14g of heat exchanger 14 is in contact with frame 12d in back plate 12a. Frame 12d has flange 12i at end edge of front face 12f, and flange 12i protrudes outward. Enclosure 12b and frame 12d are fixed together by screwing from front face 12f to back plate 12g.

Enclosure 12b has a shape that covers a front face of heat exchanger 14 and bottom face 14g of heat exchanger 14. Enclosure 12b is disposed so that heat exchanger 14 can be pushed into back plate 12a. First vent 9 is disposed in a position opposing to first flow outlet 14b in a front and upper section of enclosure 12b, and first intake hole 8 is disposed in a position opposing to first flow inlet 14a in bottom face 12h of enclosure 12b. V-shaped flexure section 29 opposing to V rib 28 is disposed in an end of bottom face 12h of enclosure 12b. Packing 30 is disposed inside a periphery of first intake hole 8.

A method for mounting heat exchanger 14 to main body case 12 described above is demonstrated hereinafter. Heat exchanger 14 is housed in frame 12d so that a periphery of bottom face 14g of heat exchanger 14 contacts a base of V rib 28. Enclosure 12b is disposed on the front face of heat exchanger 14. Heat exchanger 14 is pressed against back plate 12a when enclosure 12b and frame 12d are fixed together with screws. Front face 28a of V rib 28 is brought into contact with V-shaped flexure section 29 disposed in enclosure 12b, so that the force applied to back face 12g is distributed upward. Thus, heat exchanger 14 is pressed in two directions, i.e. to back face 12g and in upward direction, whereby heat exchanger 14 is sealed hermetically with packing 26, packing 27 and packing 30. Thus, heat exchanger 14 is sandwiched by back plate 12a and enclosure 12b with the aid of the contact between front face 28a of V rib 28 and V-shaped flexure section 29.

Frame 12d supports enclosure 12b by flange 12i and is fixed with screws or rivets. In other words, this structure avoids interference between the screws or rivets and heat exchanger 14. Heat exchanger 14 is thus detachable without damage.

As shown in Fig. 8, air blower 13 is covered by trapezoidal fan casing 12c. In fan casing 12c, since one side surface of a trapezoid serves as an intake hole and an upper bottom surface of the trapezoid (a longer side of the trapezoid) is oriented toward first flow inlet 14a, these two surfaces are open. Fan blower 13 is a turbo type centrifugal fan. A rotary shaft of fan blower 13 is disposed vertically to the surface which is the intake hole of fan casing 12c. In fan casing 12c described above, air blown out from centrifugal air blower 13 hits against side surfaces of fan casing 12c and the air is boosted on a lower bottom (a shorter side of the trapezoid). The air is then sent to first flow inlet 14a disposed at the upper bottom surface (the longer side of the trapezoid). Since the side surfaces of fan casing 12c are broadened toward first flow inlet 14a, outdoor air 19 fluently and efficiently flows in heat exchanger 14.

Drain hole 31 is disposed adjacent to a bottom face of fan casing 12c, so that the water entered in heat exchanging apparatus 6 can be discharged. Since drain hole 31 is disposed in front of air blower 13, the water is smoothly discharged.

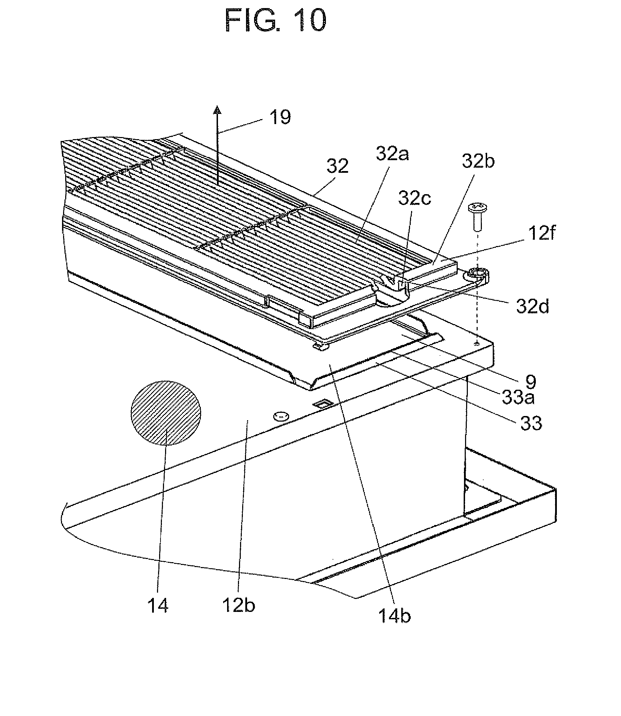

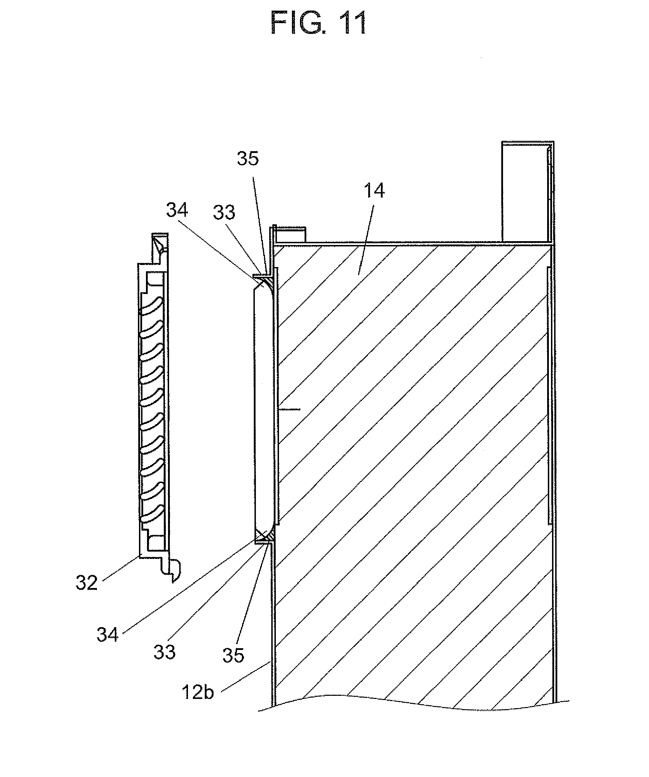

Fig. 10 is a perspective view of the first vent of the heat exchanging apparatus in accordance with the embodiment of the present invention. Fig. 11 is a sectional view of the first vent of the heat exchanging apparatus in accordance with the embodiment of the present invention. As shown in Fig. 10 and Fig. 11, first vent 9 is disposed in enclosure 12b and connected to first flow outlet 14b of heat exchanger 14. Louver 32 connected to first vent 9 is disposed in first vent 9. Louver 32 comprises flap section 32a through which the discharged air, i.e. outdoor air 19, passes, and frame section 32b mounted to enclosure 12b and placed around flap section 32a. Groove 32c is disposed between frame section 32b and flap section 32a, and groove 32c sinks in toward enclosure 12b.

Bent section 33 which fits to groove 32c is disposed around first vent 9 of enclosure 12b. Bent section 33 is oriented toward downstream of the vent. In first vent 9 described above, bent section 33 fits to groove 32c so that top 33a of bent section 33 contacts bottom 32d of groove 32c disposed in front face 12f of louver 32.

Caulking 34 is applied between bent section 33 and heat exchanger 14 to prevent immersion of water into enclosure 12b. Right-angled wall section 35 undergone the caulking application is formed between bent section 33 and heat exchanger 14, so that condition of caulking 34 can be checked.

Louver 32 is screwed down with flange 12i disposed in frame 12d and enclosure 12b shown in Fig. 9 by using screws. Thus, louver 32 is rigidly mounted to enclosure 12b with the aid of flange 12i. Therefore, heat exchanger 14 can not be damaged in screw tightening of louver 32. Louver 32 can be fixed with rivets.

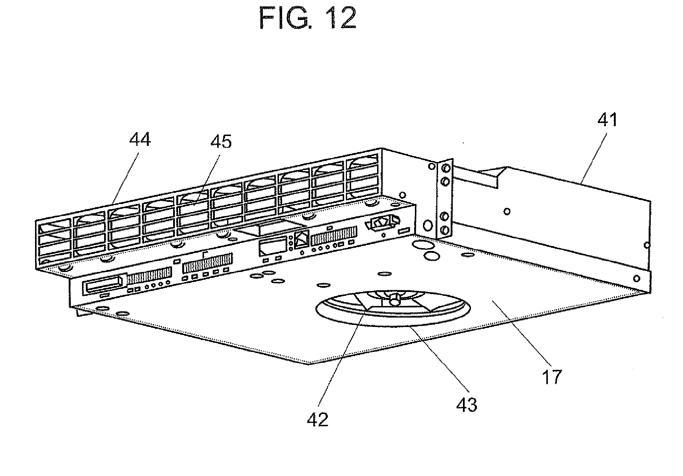

Fig. 12 is a perspective view of a circulating fan of the heat exchanging apparatus in accordance with the embodiment of the present invention. As shown in Fig. 12, circulating fan 17 is disposed on the top plate of cabinet 4 (Fig. 3) and housed in thin box case 41. Circulating fan 17 has therein turbo type centrifugal blower 42, and has intake hole 43 of circulating fan 17 at a bottom surface and vent 44 of circulating fan 17 on one side surface. Vent 44 of circulating fan 17 has lattice-shaped bars. Multiple straightening plates 45 for rectifying blown airflow are disposed in an inside of vent 44 of circulating fan 17. Straightening plate 45 is disposed on the upstream side of vent 44 of circulating fan 17 so that its upper side contacts a top plate of case 41. Straightening plate 45 is disposed such that its side facing the upstream side tilts toward a high-pressure side of air flow generated by an impeller of circulating fan 17. In other words, the impeller is tilted toward the downstream.

In the structure described above, a wind speed of the impeller of circulating fan 17 is faster on a side of a main plate (a surface opposing to intake hole 43 of circulating fan 17) of the impeller. Straightening plate 45 is disposed where the wind speed is faster, and straightening vanes 45 is removed where the wind speed is relatively low to reduce a resistance and then a vertical wind speed can be uniformed. Variations in airflow distribution can be seen in vent 44 of circulating fan 17, but the uniformed air flow flows in heat exchanger 14 shown in Fig. 3 due to the tilt of straightening plate 45. Heat-exchange efficiency of heat exchanger 14 is improved by feeding the uniformed air flow into heat exchanger 14.

As shown in Fig. 8, drain hole 12e is disposed in a position corresponding to a lower section of heat exchanger 14, i.e. a lower bottom of frame 12d, in main body case 12. Since the air flows in heat exchanger 14 by air blower 13 and circulating fan 17 shown in Fig. 3, an inside of main body case 12 has positive pressure. If water enters main body case 12 shown in Fig. 8 through gaps between packing 26, 27 and 30 shown in Fig. 9, the water is discharged by positive pressure air through drain hole 12e disposed in the lower bottom of frame 12d. Water cannot flow out through second vent 11 disposed downstream of main body case 12 shown in Fig. 3. As a result, malfunctions and faults caused by the immersion of water in electronic devices in cabinet 4 can be avoided.

### INDUSTRIAL APPLICABILITY

A heat exchanging apparatus in accordance with the embodiment of the present prevention is extremely useful as a cooling unit for a base station, having a limited lot size, of communication devices and other outdoor equipment.

### REFERENCE MARKS IN THE DRAWINGS

- 1: building
- 2: rooftop
- 3: base station
- 4: cabinet
- 5: transceiver
- 6: heat exchanging apparatus
- 7: door
- 8: first intake hole
- 9: first vent
- 10: second intake hole
- 11: second vent
- 12: main body case
- 12a: back plate
- 12b: enclosure
- 12c: fan casing
- 12d: frame
- 12e: drain hole
- 12f: front face
- 12g: back face
- 12h: bottom face of enclosure
- 12i: flange
- 12j: front face of frame
- 12k: bottom face of frame
- 13: air blower
- 14: heat exchanger
- 14a: first flow inlet
- 14b: first flow outlet
- 14c: second flow inlet
- 14d: second flow outlet
- 14e: welding line
- 14f: joint face
- 14g: bottom face of heat exchanger
- 15a: first plate
- 15b: second plate
- 15c: first side
- 15d: second side
- 15e: third side
- 15f: fourth side
- 15g: fifth side
- 15h: sixth side
- 16a: L-shaped blowing lane
- 16b: U-shaped blowing lane
- 17: circulating fan
- 18: face of stacked body
- 18a: first stack face
- 18b: second stack face
- 18c: third stack face
- 19: outdoor air
- 20: indoor air
- 21a: straightening vane A
- 21b: straightening vane B
- 22a: first shelter wall
- 22b: second shelter wall
- 22c: third shelter wall
- 22d: fourth shelter wall
- 22e: first protrusion section
- 22f: second protrusion section
- 22g: lower section
- 23: liquid reservoir
- 26, 27, 30: packing
- 28: V rib
- 28a: front face of V rib
- 29: V-shaped flexure section
- 31: drain hole
- 32: louver
- 32a: frap section
- 32b: frame section
- 32c: groove
- 32d: bottom of groove
- 33: bent section
- 33a: top of bent section
- 34: caulking
- 35: wall section
- 41: case
- 42: centrifugal blower
- 43: intake hole of circulating fan
- 44: vent of circulating fan
- 45: straightening plate

## Claims

1. A heat exchanging apparatus disposed in a cabinet, comprising:
a main body case having a first intake hole for sucking outdoor air and a first vent for blowing the outdoor air in a front face of the cabinet, and a second intake hole for sucking indoor air within the cabinet and a second vent for blowing the indoor air in a back face of the cabinet;
a blower fan disposed in the main body case for both sucking and blowing the outdoor air;
a heat exchanger for exchanging heat between the outdoor air and the indoor air in the main body case,
wherein:
the heat exchanger is formed by alternately stacking first plates and second plates so as to be spaced apart a predetermined distance from each other,
the first plates have L-shaped blowing lanes on each surface, the second plates have U-shaped blowing lanes on each surface,
a first flow inlet for sucking the outdoor air sucked from the first intake hole into the heat exchanger is disposed on a first face of the stacked body, and the first face is any one of faces of the stacked body formed by alternately stacking the first plates and the second plates,
a first flow outlet for blowing the outdoor air from the heat exchanger is disposed on a second face of the stacked body, and the second face is adjacent to the first face,
a second flow inlet for sucking the indoor air into the heat exchanger and a second flow outlet for blowing the indoor air from the heat exchanger are disposed on a third face of the stacked body, and the third face confronts the second face of the stacked body,
the first face of the stacked body is oriented toward the blower fan, and
the first flow outlet, the second flow outlet, and the second flow inlet are disposed so as to contiguous to the first vent, the second vent, and the second intake hole, respectively.

2. The heat exchanging apparatus according to claim 1, wherein
the second flow inlet is vertically disposed above the second flow outlet and the second flow outlet is vertically disposed below the second flow inlet in the U-shaped blowing lane,
in a front view of the U-shaped blowing lane, each one the second plates is formed by four sides including a second side and a first side having the second flow inlet and the second flow outlet, and comprises:
a first shelter wall disposed at a periphery including three sides other than the first side; and
a second shelter wall disposed at the first side other than the second flow inlet and the second flow outlet,
wherein the second side includes a slope rising toward the second flow outlet.

3. The heat exchanging apparatus according to claim 1, wherein the heat exchanger is formed by welding after the first plates and the second plates are temporarily bound by a straight welding line in the stacked direction.

4. The heat exchanging apparatus according to claim 3, wherein
water-proof coating is applied to a joint face of the heat exchanger after the welding.

5. The heat exchanging apparatus according to claim 1, wherein the heat exchanger is formed by successively stacking the first plates or the second plates at ends of the stacked body.

6. The heat exchanging apparatus according to claim 2, wherein in a front view of the L-shaped blowing lane, each one of the first plates is formed by four sides composed of a third side and a fourth side which are short sides, and a fifth side and a sixth side which are long sides, and comprises:
a third shelter wall disposed at a periphery of the third side and the fifth side of the L-shaped blowing lane;
a fourth shelter wall disposed at a part of the sixth side, and
multiple second protrusion sections which are inserted to an inside of the third shelter wall are formed in the second shelter wall,
multiple first protrusion sections which are inserted to the second shelter wall are formed in the third shelter wall,
a top of the second protrusion section contacts a top of the third shelter wall, and
a top of the first protrusion section contacts a section other than the second protrusion section of the second shelter wall, and the third shelter wall and the second shelter wall fit to each other.

7. The heat exchanging apparatus according to claim 1, wherein
the main body case comprising:
a back plate on the back face;
a frame fixed to the back plate;
an enclosure covering a front face of the frame and a bottom face of the frame; and
a fan casing covering the blower fan,
wherein
the enclosure has a bent section oriented toward downstream around the first vent,
caulking is applied to a wall section formed between the bent section and the heat exchanger.

8. The heat exchanging apparatus according to claim 7, wherein
a louver connected to the first vent is disposed,
the louver comprises a flap section through which the outdoor air passes and a frame section which is mounted to the enclosure, and a groove which fits to the bent section is disposed between the frame section and the flap section,
a top of the bent section contacts a bottom of the groove.

9. The heat exchanging apparatus according to claim 7, wherein
a V rib with a descending slope toward the front face is disposed in a section where the bottom face of heat exchanger contacts the frame in the back plate, and a V-shaped flexure section is disposed in a bottom face of the enclosure, and the heat exchanger is sandwiched by the back plate and the enclosure with the aid of contact between the front face of the V rib and the V-shaped flexure section.

10. The heat exchanging apparatus according to claim 8, wherein
the frame has a flange which is projected outward toward an end of the front face and is rigidly mounted with an aid of the flange that supports the enclosure.

11. The heat exchanging apparatus according to claim 10, wherein
the louver is fixed to the enclosure with the aid of the flange.

12. The heat exchanging apparatus according to claim 1, wherein
packings are disposed respectively between the second flow inlet and the second intake hole, and between the second flow outlet and the second vent.
